# EUROPEAN PATENT SPECIFICATION

(11) **EP 0 278 765 B1**
(45) Date of publication and mention of the grant of the patent: **27.04.1994**
(21) Application number: 88301140.5
(22) Date of filing: 11.02.1988
(51) Int. Cl.: H03H 9/64, H03H 9/145

(54) **Surface acoustic wave filter**
Akustisches Oberflächenwellen-Filter
Filtre à ondes acoustiques de surface

(30) Priority: 13.02.1987 JP 29688/87; 14.05.1987 JP 115805/87; 17.11.1987 JP 288376/87
(43) Date of publication of application: 17.08.1988
(73) Proprietor: KABUSHIKI KAISHA TOSHIBA, Kawasaki-shi, Kanagawa-ken 210 (JP)
(72) Inventor: Nozaki, Masao c/o Patent Division, Minato-ku Tokyo (JP); Yasuhara, Yoshihiko c/o Patent Division, Minato-ku Tokyo (JP)
(74) Representative: Freed, Arthur Woolf

(56) References cited:
- EP-A- 0 028 265
- EP-A- 0 063 839
- US-A- 3 813 618
- US-A- 3 968 461
- US-A- 3 987 376
- PATENT ABSTRACTS OF JAPAN, vol. 8, no. 213 (E-269)[1650], 28th September 1984 & JP-A-59 99 810
- ELECTRONICS LETTERS, vol. 10, no. 19, 19th September 1974, pages 395-396; H. ENGAN: "High-frequency operation of surface-acoustic-wave multielectrode transducers"

## Description

This invention relates to a surface acoustic wave filter (SAW filter) used as a delay-line, a filter and so on, more particularly, to a SAW filter which has an electrode structure for preventing third harmonics.

During the past few years there has been an increasing use of SAW filters for Picture Intermediate Frequency (PIF) circuit of TV receivers and the demand for the filter will continue to increase.

A basic structure of the SAW filter is constructed with a first transducer of an input electrode and a second transducer of an output electrode facing to the first transducer on a piezoelectric substrate comprising lithium tantalate (LiTaO₃), lithium niotate oxide (LiNbO₃), quartz and so on.

Each of these transducers comprises a comb-shaped anode electrode of a plurality of electrode fingers and a comb-shaped cathode electrode of a plurality of electrode fingers crossing each other.

Generally, a desired choice of a frequency characteristic can be realized by making a different length of electrode fingers of the anode and cathode electrodes forming at least one of the first transducer and the second transducer.

The transducer with a different length of the electrode fingers is generally called as Apodized electrode (the weighted type electrode) and the other transducer with a constant length of the electrode fingers is called as an unweighted electrode.

A center frequency f₀ in a passband of a frequency amplitude characteristic of the SAW filter which is constructed with the Apotized electrode and the unweighted electrode, will be determined as follows. In other words, the unweighted electrode has an electrode pitch (the distance between the approximate centers of the adjacent electrode fingers) which is defined by the center frequency f₀. On the other hand, the Apodized electrode has an electrode pitch which is defined by a frequency in the vicinity to the center frequency f₀. When both of the first and second transducers are constructed with the Apodized electrode, it is general to arrange between the transducers a multi-strip coupler with a pluralityt of electrode fingers having a constant space in between.

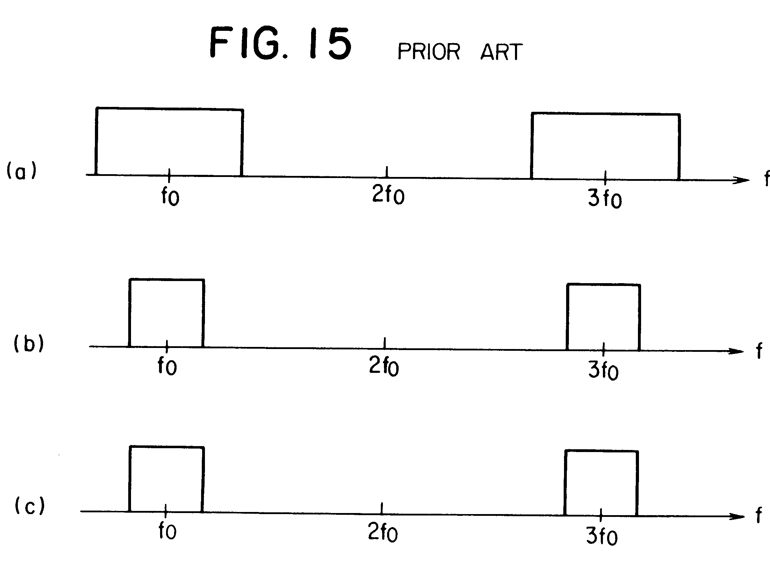

The frequency characteristic of the conventional SAW filter using the above multi-strip coupler will be explained with reference to Fig. 15 (a) and a frequency characteristic of the second transducer is shown in Fig. 15 (b).

As it is understood from the drawings in Fig. 15 (a) and (b), frequencies f₀ and 3f₀ are to be a passband (a frequency passband) of both the first and second transducers. The frequency characteristic of the SAW filter is expressed by the product of the frequency characteristic of the first transducer and that of the second transducer so that the frequency characteristic of the SAW filter is shown in Fig. 15 (c).

It is clear from the Fig. 15 (c), that the frequency characteristic of the SAW filter has passbands not only in the vicinity to f₀ but also in the vicinity to 3f₀ in which so-called third harmonics appears. This third harmonic is to be a cause of the characteristic degradation of the SAW filter, especially it is considered to be very important for TV receivers and so on.

In order to prevent the third harmonics, it is known that one of the transduers is constructed with a solid electrode. The solid electrodde in this case means an unweighted electrode in which the width of the electrode and the space between the electrodes are equal in size to each other.

For manufacturing the above structure of the SAW filter, the electrode should be formed in such a way that the width of the electrode is completely equal to the space between the electrodes in size, which has problems of requiring a very accurate manufacturing technique, decreasing its yield of production and increasing its manufacturing cost.

US-A-3,813,618 discloses a technique for suppressing residual peaks in a narrow-band electromechanical filter. However, this technique is to pass only specified peaks among a plurality of primary peaks in a periodic filter. This reference does not suggest the suppression of third harmonics.

An object of the invention is to provide an improved surface acoustic wave filter which reduces third harmonics and has an improved frequency characteristic.

Another object of the invention is to avoid the accurate electrode manufacturing process for the filter which can be made easily and which does not have third harmonics.

Still another object of the invention is to provide the filter having no third harmonics, at low cost.

One aspect of the present invention provides a surface acoustic wave filter, comprising: a piezoelectric substrate; a first transducer including comb-shaped electrodes with a plurality of electrode fingers crossing each other formed on one major surface of the piezoelectric substrate; and a second transducer including comb-shaped electrodes with a plurality of electrode fingers crossing each other formed on the one major surface of the piezoelectric substrate and being faced to the first transducer; wherein a frequency amplitude characteristic of the filter has a frequency passband in a vicinity to the frequency amplitude characteristic of a frequency fₒ: wherein an electrode pitch of the first transducer and that of the second transducer comply with;

$\text{|f₁ - f₂ | ≧1/8| (Δf₁+Δf₂)|}$

wherein Δf₁ stands for the frequency passband width of the first transducer, Δf₂ for the frequency passband width of the second transducer, f₁ for the frequency of the first transducer defining the electrode pitch of the first transducer, and f₂ for the frequency of the second transducer defining the electrode pitch of the second transducer.

A second aspect of the present invention provides a surface acoustic wave filter, comprising: a piezoelectric substrate; a first transducer including comb-shaped electrodes with a plurality of electrode fingers crossing each other formed on one major surface of the piezoelectric substrate; and a second transducer including comb-shaped electrodes with a plurality of electrode fingers crossing each other formed on the one major surface of the piezoelectric substrate and being faced to the first transducer; wherein the filter has a frequency passband width Δfₒ whose the center frequency is fₒ: wherein an electrode pitch of the first transducer and that of the second transducer comply with;

${\text{4f}}_{\text{x}} {\text{-f₁≧3f}}_{\text{o}} {\text{+Δf}}_{\text{o}} \text{/2 + Δf₁/2.}$

or

${\text{4f}}_{\text{x}} {\text{-f₁≦3f}}_{\text{o}} {\text{-Δf}}_{\text{o}} \text{/2 - Δf₁/2.}$

wherein Δfₒ stands for a frequency passband width of the first transducer, fₒ for the center frequency of Δfₒ, Δf₁ for a frequency passband width of the second transducer, f₁ for the center frequency of Δf₁, and fₓ for the frequency defining an electrode pitch of the adjacent electrode fingers of the second transducer.

A third aspect of the present invention provides a surface acoustic wave filter, comprising: a piezoelectric substrate; a first transducer including comb-shaped electrodes with a plurality of electrode fingers crossing each other formed on one major surface of the piezoelectric substrate; and a second transducer including comb-shaped electrodes with a plurality of electrode fingers crossing each other formed on the one major surface of the piezoelectric substrate and being faced to the first transducer; wherein the filter has a frequency passband width Δfₒ whose the center frequency is fₒ: wherein an electrode pitch of the first transducer and that of the second transducer comply with;

${\text{f₁≦f}}_{\text{o}} \text{-Δf₀/6 -Δf₁/6}$

or

${\text{f₁≧f}}_{\text{o}} {\text{+Δf}}_{\text{o}} \text{/6 + Δf₁/6.}$

wherein Δfₒ stands for a frequency passband width of the first transducer, fₒ for the center frequency of Δfₒ, Δf₁ for a frequency passband width of the second transducer, and f₁ for the center frequency of Δf₁.
Fig. 1 is a type plan for explaining an embodiment of the SAW filter according to the present invention;
Fig. 2 (a) through Fig. 2 (c) are the frequency characteristic diagrams for explaining the effect of the embodiment shown in Fig. 1;
Fig. 3 (a) through Fig. 3 (c) are the frequency characteristic diagrams for explaining the effect of the embodiment shown in Fig. 1;
Fig. 4 is a type plan for explaining another embodiment of the SAW filter according to the present invention;
Fig. 5 (a) through Fig. 5 (c) are the frequency characteristic diagrams for explaining the effect of the embodiment shown in Fig. 4;
Fig. 6 is a type plan for explaining another embodiment of the SAW filter according to the present invention;
Fig. 7 (a) through Fig. 7 (c) are the frequency characteristic diagrams for explaining the effect of the embodiment shown in Fig. 6;
Fig. 8 (a) through Fig. 8 (c) are the frequency characteristic diagram for explaining the effect of the embodiment shown in Fig. 6;
Fig. 9 is a type plan for explaining another embodiment of the SAW filter according to the present invention;
Fig. 10 is a type plan for explaining another embodiment of the SAW filter according to the present invention;
Fig. 11 (a) through Fig. 11 (c) are the frequency characteristic diagrams for explaining the effect of the embodiment shown in Fig. 10;
Fig. 12 (a) through Fig. 12 (c) are the frequency characteristic diagrams for explaining the effect of the embodiment shown in Fig. 10;
Fig. 13 is a type plan for explaining another embodiment of the SAW filter according to the present invention;
Fig. 14 is a patially enlarged plan view of the electrode for explaining another embodiment of the SAW filter according to the present invention; and
Fig. 15 (a) through Fig. 15 (c) are the frequency characteristic diagrams for explaining a conventional SAW filter.

Referring to the drawings, embodiments of the SAW filter according to the present invention will be explained.

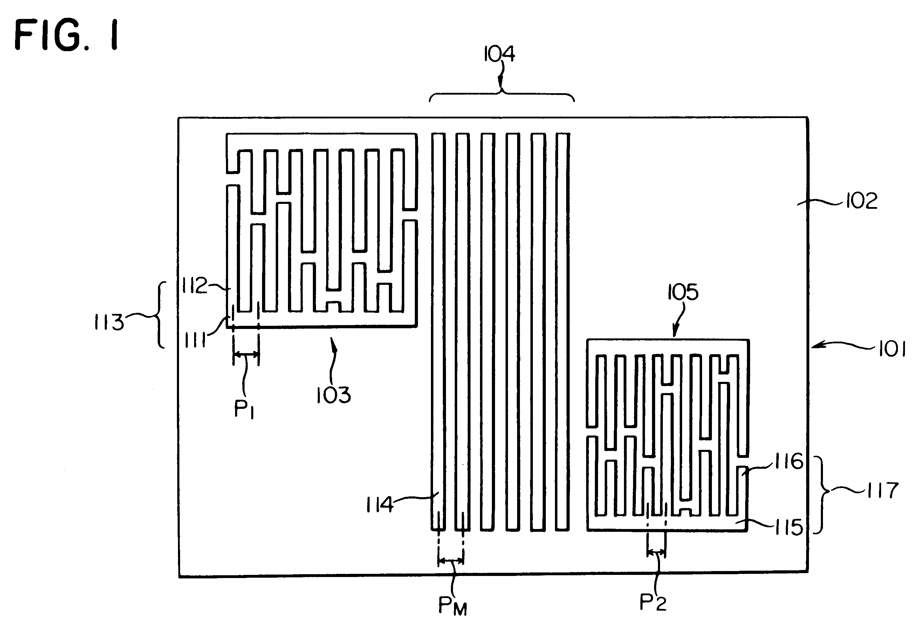

Fig. 1 shows the electrode construction of the embodiment of the SAW filter.

As shown in Fig. 1, a surface acoustic wave filter 101 comprises a first transducer 103 formed on a piezoelectric substrate 102 of lithium tantalate oxide (LiTaO₃), lithium niobate oxide (LiNbO₃), lithium tetraborate (Li₂B₄O₇) quartz and so on, a multi-strip coupler 104 by which a surface acoustic wave existed from the first transducer 103 is put in on-way, a second transducer 105 for receiving the surface acoustic wave formed in the position of about point symmetry to the first transducer 103.

Hereupon, a frequency amplitude characteristic of the SAW filter 101 has a frequency passband in the vicinity to the frequency amplitude characteristic of a frequency f₀.

The first transducer 103 comprises an electrode of aluminum in which one end of a plurality of electrode fingers 112 crossing each other is electrically short-circuited by a bus bar 111 to construct a comb-shaped electrode 113.

The crossing structure of the electrode fingers 112 is so called "weighted" so that the first transducer 103 is formed as Apodized electrode.

The first transducer 103 is the Apodized electrode which has a frequency passband width of Δf₁, a frequency passband in the vicinity to the frequency characteristic of the frequency f₀ and an electrode pitch P₁ of the 1/4 wave length λ of the surface acoustic wave corresponding to a frequency f₁.

The multi-strip coupler 104 comprises an electrode of aluminum in which each of a plurality of electrode fingers 114 is arranged with a constant electrode pitch P_{M} defined by the frequency f₀.

The second transducer 105 comprises an electrode of aluminum in which one end of a plurality of electrode fingers 116 crossing each other is electrically short-circuited by a bus bar 115 to construct a comb-shaped electrode 117. The crossing structure of the electrode fingers 116 is so called "weighted" so that the second transducer 105 is formed as Apodized electrode.

The second transducer 105 is the Apodized electrode which has a frequency passband width of Δf₂, a frequency passband in the vicinity to the frequency amplitude characteristic of the frequency f₀ and an electrode pitch P₂ of the 1/4 wave length λ of the surface acoustic wave corresponding to a frequency f₂.

Then, it will be explained the frequencies f₁ and f₂ which define the electrode pitch of the first transducer 103 and that of the second transducer 105 respectively.

First, it will be explained when the frequencies f₁ and f₂ have the relation of f₁ > f₂.

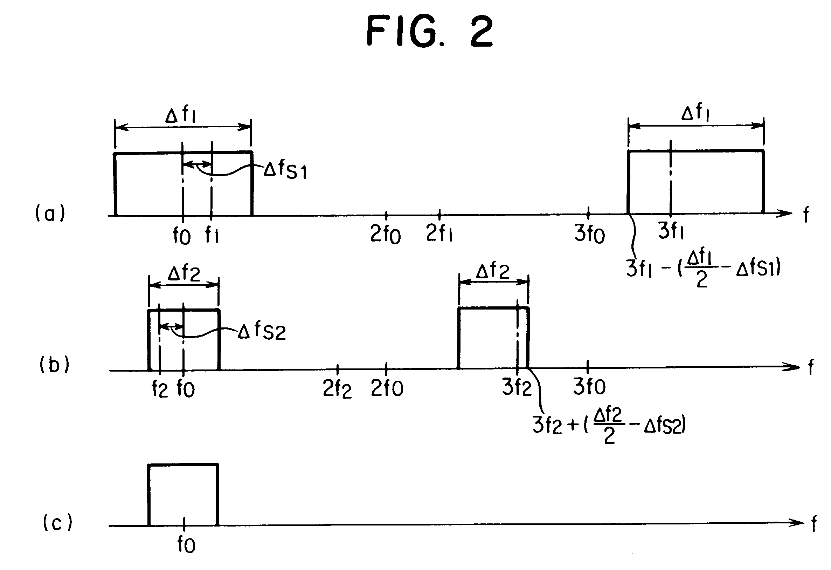

Fig. 2 (a) shows the frequency characteristic of the first transducer 103, and Fig. 2 (b) shows the frequency characteristic of the second transducer 105.

In case of SAW filter as shown in Fig. 1, in order to prevent the production of third hamonics, a frequency passband in the vicinity to the frequency 3f₀ of the first transducer 103 should not overlap with a frequency passband in the vicinity to the frequency 3f₀ of the second transducer 105 (defined as "condition (A₁)").

As to Fig. 2 (a) of the first transducer 103, the passband in the vicinity to the frequency amplitude characteristics of f₀ are symmetrical to each other about the frequency 2f₁ as the center of the symmetry.

Therefore,

${\text{Δf}}_{\text{s1}} \text{= f₁ - f₀ (1)}$

is taken,
third harmonics of the first transducer 103 commence with:

${\text{3f₁ - (Δf/2 - Δf}}_{\text{s1}} \text{) (2)}$

In the same way, as to Fig. 2 (b) of the second transducer 105, the passbands in the vicinity to the frequency amplitude characteristic of f₀ and that of 3f₀ are symmetrical to each other about the frequency 2f₂ as the center of the symmetry.

Threfore,

${\text{Δf}}_{\text{s2}} \text{= f₀ - f₂ (3)}$

is taken,
third harmonics of the second transducer 105 end with:

${\text{3f₂ + (Δf₂/2 - Δf}}_{\text{s2}} \text{) (4)}$

Now, in order to satisfy the above condition (A₁), the formula (4) should be less than or equal to the formula (2) so that the formula is:

${\text{3f₂ + (Δf₂/2 - Δf}}_{\text{s2}} \text{)}$
${\text{≦ 3f₁ - (Δf₁/2 - Δf}}_{\text{s1}} \text{)}$

The formulas (1), (2) are substituted for the above formula:

$\text{3f₂ + (Δf₂/2 - f₀ + f₂)}$
$\text{≦ 3f₁ - (Δf₁/2 - f₁ + f₀)}$
$\text{∴ f₁ - f₂ ≧ 1/8 (Δf₁ + Δf₂) (5)}$

is given.

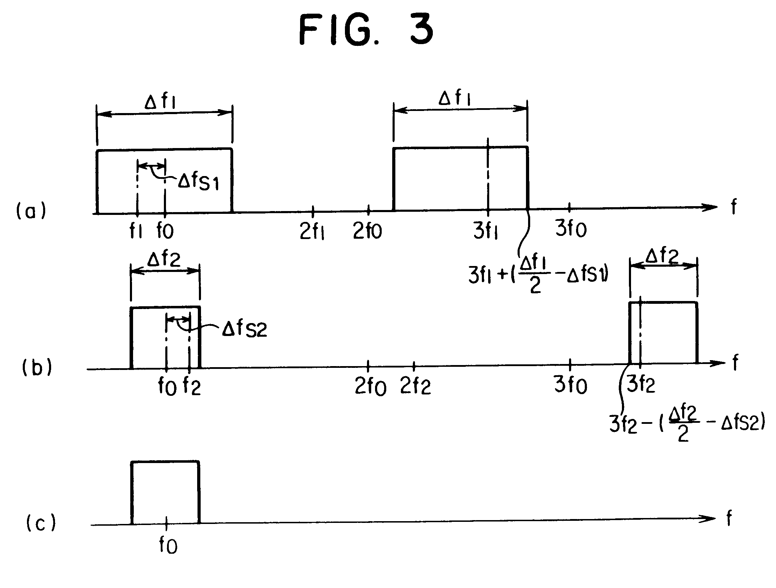

Next, it will be explained when the frequencies f₁, f₂ have the relation of f₂ < f₁ with reference to Fig. 3. In Fig. 3 (a),

${\text{Δf}}_{\text{s1}} \text{= f₀ - f₁ (6)}$

is taken,
third harmonics of the first transducer 103 end with:

${\text{3f₁ + (Δf₁/2 - Δf}}_{\text{s1}} \text{) (7)}$

In Fig. 3 (b),

${\text{Δf}}_{\text{s2}} \text{= f₂ - f₀ (8)}$

is taken,
third harmonics of the second transducer 105 commence with:

${\text{3f₂ - (Δf₂/2 - Δf}}_{\text{s2}} \text{) (9)}$

Now, in order to satisfy the condition (A₁), the formula (7) should be less than or equal to the formula (9) so that the formula is:

${\text{3f₁ + (Δf₁/2 - Δf}}_{\text{s1}} \text{)}$
${\text{≦ 3f₂ - (Δf₂/2 - Δf}}_{\text{s2}} \text{)}$

The formulas (6), (8) are substituted for the above formula:

$\text{3f₁ + (Δf₁/2 - f₀ + f₁)}$
$\text{≦ 3f₂ - (Δf₂/2 - f₂ + f₀)}$
$\text{∴ f₂ - f₁ ≧ 1/8 (Δf₁ + Δf₂) (10)}$

is given.

Now, the formulas (5) and (10) are combined so that:

$\text{|f₁ - f₂| ≧ 1/8 (Δf₁ + Δf₂) (11)}$

is given.
In other words, when the electrode pitches of the first and second transducers are determined respectively by the frequencies f₁ and f₂ to satisfy the formula (11), an extremly good characteristic as shown in Fig. 2 (c) and Fig. 3 (c) can be obtained without having the production of third harmonics to the frequency characteristic of the SAW filter 101 shown in Fig. 1.

Although the multi-strip coupler is used in the above mentioned embodiment, the invention is not restricted to the embodiment and can also be a SAW filter without the multi-strip coupler.

Hereinafter, it will be explained another embodiment of SAW filter without multi-strip coupler according to the present invention. In the following, the same codes are used for the indentical parts in Fig. 1.

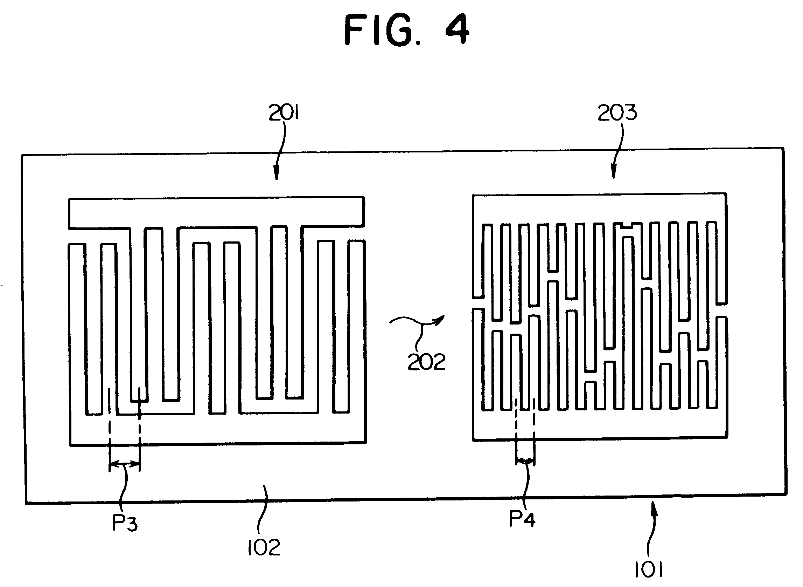

When the multi-strip coupler is not used, one of the transducers comprises the weighted type electrode and the other comprises the unweighted electrode. Fig. 4 illustrates the electrode structure of the SAW filter without the multi-strip coupler.

In Fig. 4, a surface acoustic wave filter 101 comprises a first transducer 201 formed on a piezoelectric substrate 102, a second transducer 203 for receiving a surface acoustic wave 202 exited from the first transducer 201 formed on a piezoelectric substrate 102 to face the first transducer 201. Hereupon, a frequency amplitude characteristic of a frequency f₀.

The first transducer 201 is a so-called unweighted electrode with a constant width in which the adjacent two electrode fingers are in pairs to be a double electrode.

The first transducer 201 has a center frequency of f₀, a frequency passband width of Δf₁, and an electrode pitch P₃ of the 1/4 wave length λ of the surface acoustic wave corresponding to the center frequency f₀.

The second transducer 203 is Apodized electrode which has a frequency passband width of Δf₂, a frequency passband in the vicinity to a frequency amplitude characteristic of a frequency f₀ and an electrode pitch P₄ of the 1/4 wave length λ of the surface acoustic wave corresponding to a frequency f₂.

It will be explained about frequencies f₀ and f₂ which define the electrode pitch of the first transducer 201 and that of the second transducer 203, hereafter.

First, it will be explained when the frequencies f₀, f₂ has the relation of f₀ > f₂.

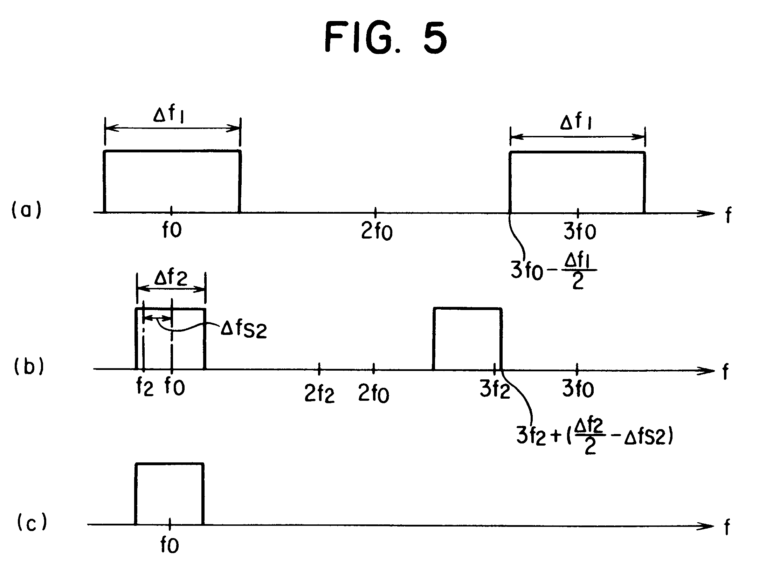

Fig. 5 (a) shows a frequency characteristic of the first transducer 201 and Fig. 5 (b) shows a frequency characteristic of the second transducer 203.

In order to satisfy the condition A₁, the following formula is obtained from Fig. 5:

${\text{3f₀ - Δf₁/2 ≧ 3f₂ + (Δf₂/2 - Δf}}_{\text{s2}} \text{) (21)}$

wherein,

${\text{Δf}}_{\text{s2}} \text{= f₀ - f₂ (22)}$

Now, the formula (22) is substituted for the formula (21):

$\text{3f₀ - Δf₁/2 ≧ 3f₂ + (Δf₂/2 - f₀ + f₂)}$
$\text{∴ f₀ - f₂ ≧ 1/8 (Δf₁ + Δf₂) (23)}$

Then, the same way is applied to the relation of f₀ < f₂ so that:

$\text{f₂ - f₀ ≧ 1/8 (Δf₁ + Δf₂) (24)}$

and the formulas (23) and (24) are combined so that:

$\text{|f₀ - f₂|= 1/8 (Δf₁ + Δf₂) (25)}$

is given.

Now, when f₀ in Fig. 5 is considered to correspond to f₁ in Fig. 3, f₀ = f₁ is substituted for the formula (25) which results in the same as the formula (11).

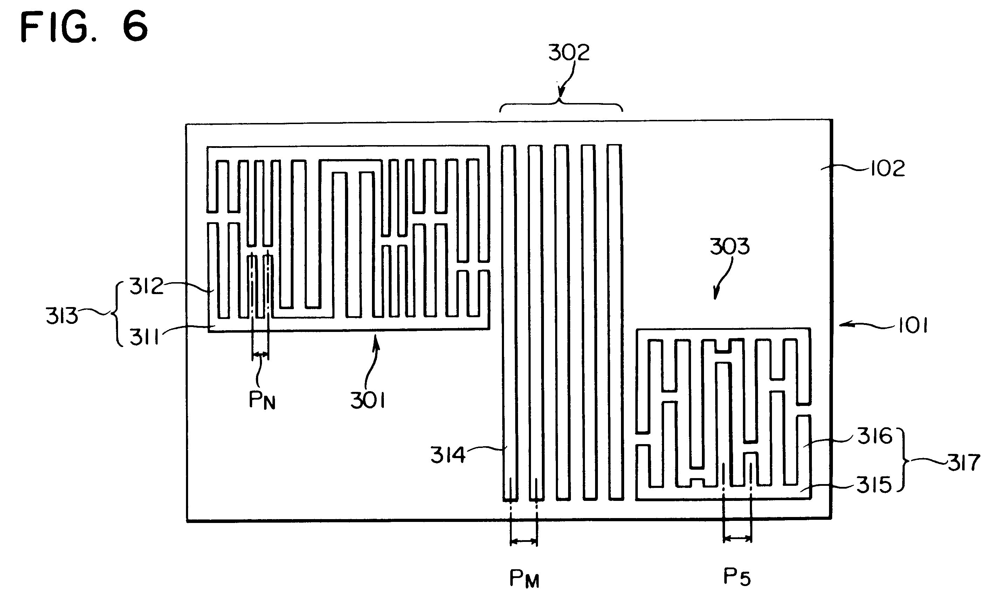

Furthermore, another embodiment according to the invention will be explained with reference to Fig. 6 to Fig. 9. In the following, the same codes are used for the indentical parts in Fig. 1.

In Fig. 6, a surface acoustic wave filter 101 comprises a first transducer 301 formed on a piezoelectric substrate 102, a multi-strip coupler 302 by which a surface acoustic wave exited from the first transducer 301 is put in on-way, a second transducer 303 for receiving the surface acoustic wave formed in the position of about point symmetry to the first transducer 301.

Hereupon, a frequency amplitude characteristics of the SAW filter 101 has a center frequency f₀ of a passband and a frequency passband width of Δf₀.

The first transducer 301 comprises an electrode of aluminum in which one end of a plurality of electrode fingers 312 crossing each other is electrically short-circuited by a bus bar 311 to construct a comb-shaped electrode 313.

The crossing structure of the electrode fingers 312 is so called "weighted" so that the first transducer 301 is formed as Apodized electrode.

The first transducer 301 is the Apodized electrode which has a frequency passband width of Δf₀, a center frequency f₀ of the frequency passband width Δf₀, and an electrode pitch P_{N} of the 1/4 wave length λ of the surface acoustic wave corresponding to the frequency f₀.

The multi-strip coupler 302 comprises an electrode of aluminum in which each of a plurality of electrode fingers 314 is arranged with a constant electrode pitch P_{M} defined by the frequency f₀.

The second transducer 303 comprises an electrode of aluminum in which one end of a plurality of electrode fingers 316 crossing each other is electrically short-circuited by a bus bar 315 to construct a comb-shaped electrode 317. The crossing structure of the electrode fingers 316 is so called "weighted" so that the second transducer 303 is formed as Apodized electrode.

The second transducer 303 is the Apodized electrode which has a frequency passband width of Δf₁, a frequency passband in the vicinity to the frequency amplitude characteristics of a frequency f₁ and an electrode pitch P₅ of the 1/4 wave length λ of the surface acoustic wave corresponding to a frequency fₓ.

Then, it will be explained a relation of the center frequency f₀ and the frequency passband width Δf₀ of the first transducer 301, the center frequency f₁ and the frequency passband width Δf₁ of the second transducer 303, and the frequency fₓ defining the electrode pitch.

First, it will be explained when the frequencies f₁ and fₓ have the relation of f₁ > fₓ.

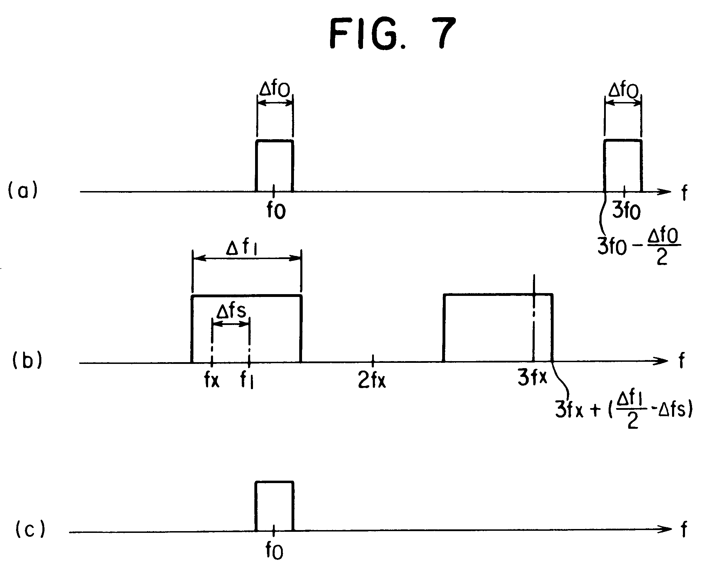

Fig. 7 (a) shows a frequency characteristic of the first transducer 301 and Fig. 7 (b) shows a frequency characteristic of the second transducer 303.

In case of the SAW filter as shown in Fig. 6, in order to prevent a production of third hamonics, a frequency passband in the vicinity to the frequency 3f₀ of the first transducer 301 should not overlap with a frequency passband in the vicinity to the frequency 3f₁ of the second transducer 303 (defined as "condition (A₂)").

As to Fig. 7 (a) of the first transducer 301, a passband in the vicinity to a frequency 3f₀ has a center frequency 3f₀ and a frequency passband width Δf₀ so that the frequency passband commences with:

$\text{3f₀ - Δf₀/2 (31)}$

As to Fig. 7 (b) of the second transducer 303, a passband in the vicinity to a frequency amplitude characteristic of f₁ and that of 3f₁ are symmetrical to each other about the frequency 2fₓ as the center of the symmetry.

Therefore,

${\text{Δf}}_{\text{s}} {\text{= f₁ - f}}_{\text{x}} \text{(32)}$

is taken,
third harmonics of the second transducer 303 end with:

${\text{3f}}_{\text{x}} {\text{+ (Δf₁/2 - Δf}}_{\text{s}} \text{) (33)}$

Now, in order to satisfy the above condition (A₂), the formula (33) should be less than or equal to the formula (31) so that the formula is:

${\text{3f}}_{\text{x}} {\text{+ (Δf₁/2 - Δf}}_{\text{s}} \text{) ≦ 3f₀ - Δf₀/2}$

The formulas (32) is substituted for the above formula:

${\text{3f}}_{\text{x}} {\text{+ (Δf₁/2 - f₁ + f}}_{\text{x}} \text{) ≦ 3f₀ -Δf₀/2}$
${\text{∴ 4f}}_{\text{x}} \text{- f₁ ≦ 3f₀ - Δf₀/2 - Δf₁/2 (34)}$

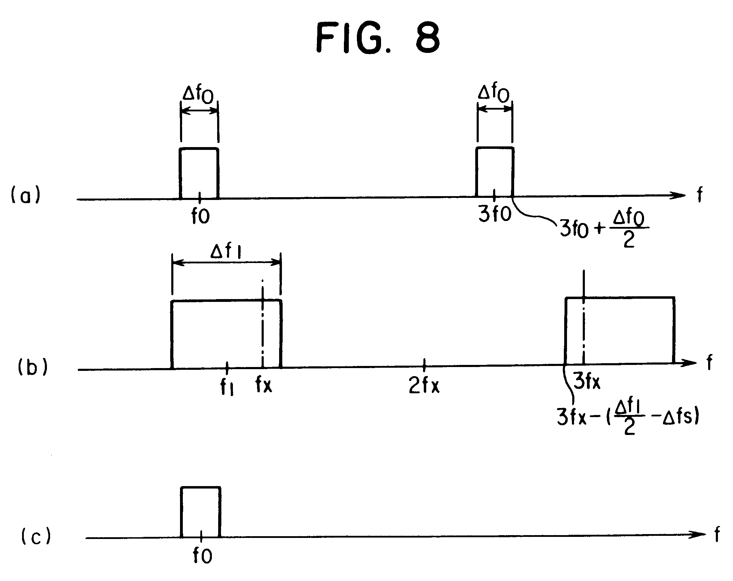

Next, it will be explained when the frequency f₁ and fₓ has the relation of f₁ < fₓ with reference to Fig. 8.

As to Fig. 8 (a) of the first transducer 301, a passband in the vicinity to the frequency amplitude characteristic 3f₀ has a center frequency 3f₀ and a frequency passband width Δf₀ so that the frequency passband ends with:

$\text{3f₀ + Δf₀/2 (35)}$

As to Fig. 8 (b) of the second transducer 303, a passband in the vicinity to the frequency amplitude characteristic of f₁ and that of 3f₁ are symmetrical to each other about the frequency 2fₓ as the center of the symmetry.

Therefore,

${\text{Δf}}_{\text{s}} {\text{= f}}_{\text{x}} \text{- f₁ (36)}$

is taken,
third harmonics of the second transducer 303 commence with:

${\text{3f}}_{\text{x}} {\text{- (Δf₁/2 - Δf}}_{\text{s}} \text{) (37)}$

Now, in order to satisfy the condition (A₂), the formula (35) should be less than or equal to the formula (37) so that the formula is:

${\text{3f₀ + Δf₀/2 ≦ 3f}}_{\text{x}} {\text{- (Δf₁/2 - Δf}}_{\text{s}} \text{)}$

The formulas (36) is substituted for the above formula:

${\text{3f₀ + Δf₀/2 ≦ 3f}}_{\text{x}} {\text{- (Δf₁/2 - f}}_{\text{x}} \text{+ f₁)}$
${\text{∴ 4f}}_{\text{x}} \text{- f₁ ≧ 3f₀ + Δf₀/2 + Δf₁/2 (38)}$

In other words, when the first and second transducers are formed so as to satisfy the formulas (34) and (38) respectively, an extremely good characteristics as shown Fig. 7 (c) and Fig. 8 (c) can be obtained without having the production of third harmonics to the frequency characteristic of the SAW filter 101 shown in Fig. 6.

Although the multi-strip coupler is used in the above mentioned embodiment, the invention is not restricted to the embodiment and can also be a SAW filter without the multi-strip coupler.

Hereinafter, it will be explained another embodiment of the SAW filter without the multi-strip coupler according to the present invention. In the following, the same codes are used for the identical parts in Fig. 6.

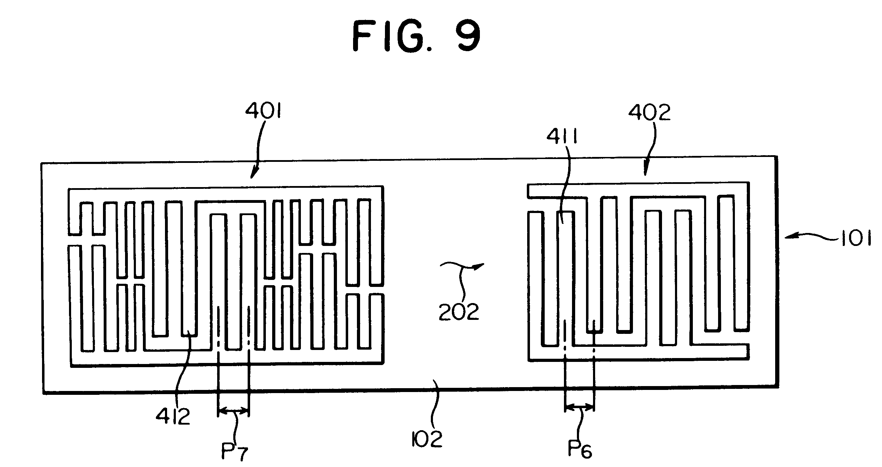

When the multi-strip coupler is not used, one of the transducers comprises the weighted type electrode and the other comprises the unweighted electrode. Fig. 9 illustrates the electrode structure of the SAW filter.

In Fig. 9, a surface acoustic wave filter 101 comprises a first transducer 401 formed on a piezoelectric substrate 102, a second transducer 402 for receiving a surface acoustic wave 202 exited from the first transducer 401 formed on piezoelectric substrate 102 to face the first transducer 401.

Hereupon, a frequency amplitude characteristic of the SAW filter 101 has a frequency passband in the vicinity to the frequency amplitude characteristic of a frequency f₀.

The second transducer 402 is a so-called unweighted electrode with a constant cross width in which the adjacent two electrode fingers are in pairs. to be a double electrode.

The second transducer 402 has a center frequency of f₁, a frequency passband width of Δf₁, and an electrode pitch P₆ which is formed by the electrode fingers 411 of the 1/4 wave length λ of the surface acoustic wave corresponding to the center frequency f₁.

The first transducer 401 comprise Apodized electrode which has a frequency passband width of Δf₀, a frequency passband in the vicinity to the frequency f₀ and an electrode pitch P₇ of the 1/4 wave length λ of the surface acoustic wave corresponding to the frequency f₀.

This case coincides with a case when the following formula is applied to Fig. 7 and Fig. 8:

${\text{f}}_{\text{x}} \text{= f₁ (41)}$

It will be explained about frequencies f₀ and f₁ which define the electrode pitch of the first transducer 401 and that of the second transducer 403 respectively, hereafter.

First, it will be explained when the frequency f₀ and f₁ have the relation of f₀ > f₁.

According to Fig. 7, a passband of the frequency characteristic 3f₀ of the first transducer commences with:

$\text{3f₀ - Δf₀/2 (42)}$

A passband of the frequency characteristic 3f₁ of the second transducer ends with:

$\text{3f₁ + Δf₁/2 (43)}$

Now, in order to satisfy the condition (A₂), the formula (43) should be less than or equal to the formula (42) so that the formula is:

$\text{3f₁ + Δf₁/2 ≦ 3f₀ - Δf₀/2}$

Then:

$\text{3f₁ ≦ 3f₀ - Δf₀/2 - Δf₁/2 (44)}$

is given.

This results in the same as that the formula (35) is substituted for the formula (34).

The same way applies to the relation of f₀ < f₁ so that

$\text{3f₁ ≧ 3f₀ + Δf₀/2 + Δf₁/2 (45)}$

is given. This results in the same as that the formula (41) is substituted for the formula (38).

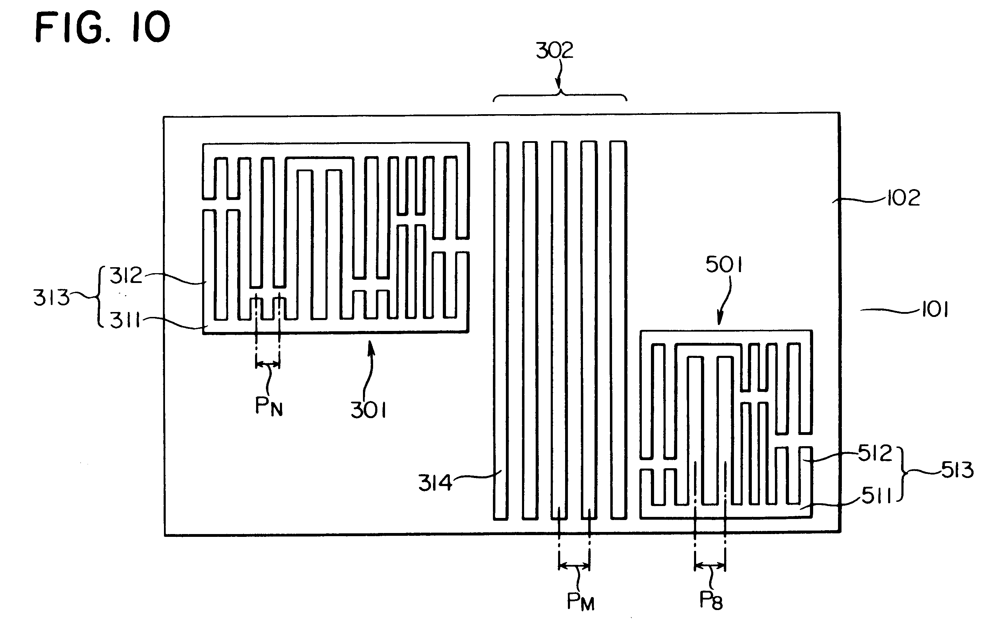

Furthermore, another embodiment according to the invention will be explained with reference to Fig. 10 to Fig. 13. In the following, the same codes are used for the identical parts in Fig. 6.

The SAW filter shown in Fig. 10 has a structure modified from the second transducer shown in Fig. 6.

Herein, a frequency amplitude chgaracteristic of the SAW filter 101 has a center frequency f₀ of a passband and a frequency passband width Δf₀.

In Fig. 10, the second transducer 501 comprises an electrode of aluminum in which one end of a plurality of electrode fingers 512 crossing each other is electrically short-circuited by a bus bar 511 to construct a comb-shaped electrode 513. The crossing structure of the electrode fingers 512 is so called "weighted" so that the second transducer 501 is formed as Apodized electrode.

This second transducer 501 is the Apodized electrode which has a frequency passband width of Δf₁, a center frequency passband f₁ of the frequency passband width Δf₁ and an electrode pitch P₈ of the adjacent electrode fingers 512 of the about 1/4 wave length λ of the surface acoustic wave corresponding to the frequency f₁.

Then, it will be explained about a relation of a center frequency f₀ and a frequency passband width Δf₀ of the first transducer 301, a center frequency f₁ and a frequency poassband width Δf₁ of the second transducer 501.

First, it will be explained when the frequencies f₀ and f₁ have the relation of f₁ < f₀.

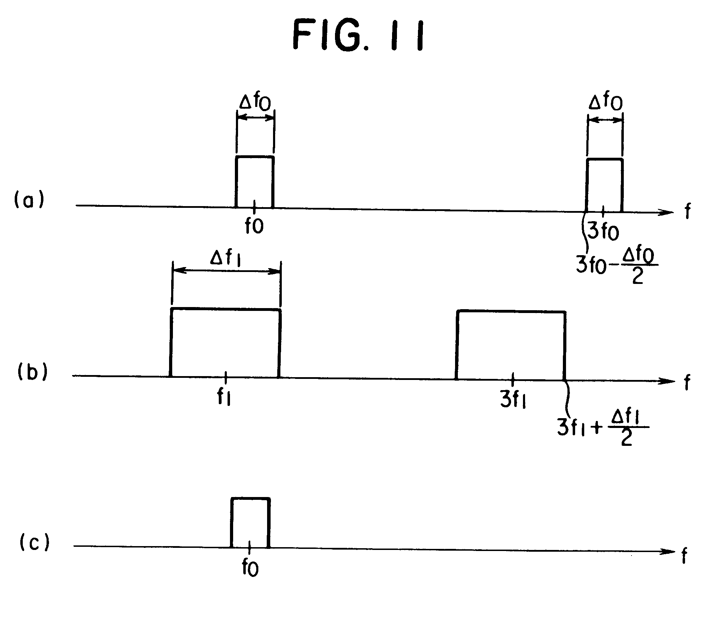

Fig. 11 (a) shows a frequency characteristic of the first transducer 301 and Fig. 11 (b) shows a frequency characteristic of the second transducer 501.

In case of the SAW filter shown in Fig.10, in order to prevent the production of third hamonics, a frequency passband in the vicinity to the frequency 3f₀ of the first transducer 301 should not overlap with a frequency passband in the vicinity to the frequency 3f₁ of the second transducer 501 in the same way as Fig. 6 (defined as "condition (A₂)").

As to Fig. 11 (a) of the first transducer 301, a passband in the vicinity to the frequency 3f₀ has a center frequency 3f₀ and a frequency passband width Δf₀ so that a frequency passband commences with:

$\text{3f₀ - Δf₀/2 (51)}$

As to Fig. 11 (b) of the second transducer 501, a passband in the vicinity to the frequency 3f₁ has a center frequency 3f₁ and a frequency passband width Δf₁ so that a frequency passband ends with:

$\text{3f₁ + Δf₁/2 (52)}$

Now, in order to satisfy the condition (A₂), the formula (52) should be less than or equal to the formula (51) so that the formula is:

$\text{3f₁ + Δf₁/2 ≦ 3f₀ - Δf₀/2}$

Then:

$\text{f₁ ≦ f₀ - Δf₀/6 - Δf₁/6 (53)}$

is given.

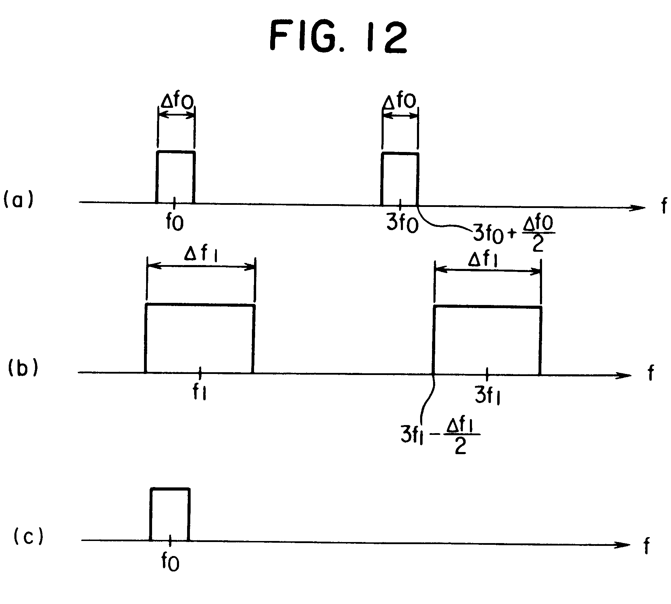

Next, it will be explained when the frequencies f₀ and f₁ have the relation of f₁ > f₀ with reference to Fig. 12.

As to Fig. 12 (a) of the first transducer 301, a passband in the vicinity to the frequency 3f₀ has a center frequency 3f₀ and the frequency passband width Δf₀ so that a frequency passband ends with:

$\text{3f₀ + Δf₀/2 (54)}$

As to Fig. 12 (b) of the second transducer 501, a passband in the vicinity to the frequency 3f₁ has a center frequency 3f₁ and a frequency passband width Δf₁ so that a frequency passband commences with:

$\text{3f₁ - Δf₁/2 (55)}$

Now, in order to satisfy the condition (A₂), the formula (54) should be less than or equal to the formula (55) so that the formula is:

$\text{3f₀ + Δf₀/2 ≦ 3f₁ - 3f₁/2}$

Then:

$\text{f₁ ≧ f₀ + Δf₀/6 + Δf₁/6 (56)}$

is given.

In other words, when the first and second transducers are formed so as to satisfy the formulas (53) and (56) respectively, and extremely good characteristics as shown Fig. 11 (c) and Fig. 12 (c) can be obtained without having the production of third harmonics to the frequency characteristics of the SAW filter 101 shown in Fig. 10.

Although the multi-strip coupler is used in the above mentioned embodiment, the invention is not restricted to the embodiment and can also be a SAW filter without the multi-strip coupler.

When the multi-strip coupler is not used, the first transducer 601 comprises the weighted type electrode and the second transducer 602 comprises the unweighted electrode. The same may apply to this case that the first and second transducers are formed so as to satisfy the formulas (53) and (56) respectively.

Furthermore, although the first transducer of the embodiment shown in Fig. 4 to Fig. 9 comprises a double electrode, the first transducer may comprise a solid electrode.

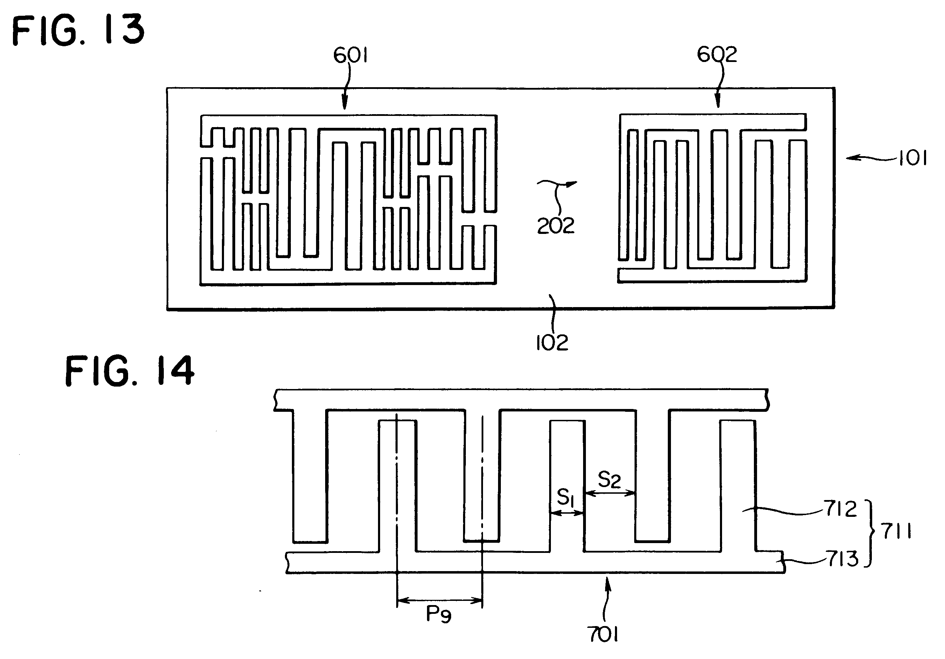

Fig. 14 shows a structure of a solid electrode, in which a formal shaped electrode 701 comprises a pair of comb-shaped electrode 711 crossing each other. This comb-shaped electrode 711 is formed as that one end of a plurality of electrode fingers 712 is electrically short-circuited by a bus bar 713.

The width s₁ of the electrode fingers 712 may not always be the same as the space (gap) s₂ between the electrode fingers 712 in size. Furthermore, the unweighted electrode 701 has an electrode pitch P₉ with a space of the 1/2 wave length λ of the SAW filter corresponding to the center frequency f₀.

## Claims

1. A surface acoustic wave filter, comprising:
a piezoelectric substrate (102);
a first transducer (103) including comb-shaped electrodes with a plurality of electrode fingers crossing each other formed on one major surface of the piezoelectric substrate (102); and
a second transducer (105) including comb-shaped electrodes with a plurality of electrode fingers crossing each other formed on the one major surface of the piezoelectric substrate (102) and being faced to the first transducer (103);
wherein a frequency amplitude characteristic of the filter has a frequency passband in a vicinity to the frequency amplitude characteristic of a frequency f₀:
the filter being characterized in that an electrode pitch of the first transducer and that of the second transducer comply with;
$\text{| f₁ - f₂ | ≧ 1/8 ( Δf₁ + Δf₂ ),}$
wherein Δf₁ stands for the frequency passband width of the first transducer, Δf₂ for the frequency passband width of the second transducer, f₁ for the frequency of the first transducer defining the electrode pitch of the first transducer, and f₂ for the frequency of the second transducer defining the electrode pitch of the second transducer.

2. The surface acoustic wave filter of claim 1, wherein the electrode pitch of a plurality of the adjacent electrodes of the first transducer and the electrode pitch of a plurality of the adjacent electrodes of the second transducer are defined by a space of the 1/4 wave length λ of the surface acoustic wave corresponding to the frequencies f₁ and f₂.

3. The surface acoustic wave filter of claim 1, wherein at least one of the frequency f₁ of the first transducer and the frequency f₂ of the second transducer approximately corresponds to the frequency f₀ of the filter.

4. The surface acoustic wave filter of claim 3, wherein the electrode pitch of the electrode fingers of the transducer approximately corresponding to the frequency f₀ is defined by a space of the 1/4 wave length λ of the surface acoustic wave corresponding to the frequency f₀.

5. The surface acoustic wave filter of claim 3, wherein the electrode pitch of the electrode fingers of the transducer approximately corresponding to the frequency f₀ is defined by a space of the 1/2 wave length λ of the surface acoustic wave corresponding to the frequency f₀.

6. A surface acoustic wave filter, comprising:
a piezoelectric substrate (102);
a first transducer (301) including comb-shaped electrodes with a plurality of electrode fingers crossing each other formed on one major surface of the piezoelectric substrate (102); and
a second transducer (303) including comb-shaped electrodes with a plurality of electrode fingers crossing each other formed on the one major surface of the piezoelectric substrate (102) and being faced to the first transducer (301);
wherein the filter has a frequency passband width Δf₀ whose the center frequency is f₀:
the filter being characterized in that an electrode pitch of the first transducer and that of the second transducer comply with;
${\text{4f}}_{\text{x}} \text{- f₁ ≧ 3f₀ + Δf₀/2 + Δf₁/2}$
or
${\text{4f}}_{\text{x}} \text{- f₁ ≦ 3f₀ - Δf₀/2 - Δf₁/2}$ ,
wherein Δf₀ stands for a frequency passband width of the first transducer, f₀ for the center frequency of Δf₀, Δf₁ for a frequency passband width of the second transducer, f₁ for the center frequency of Δf₁, and fₓ for the frequency defining an electrode pitch of the adjacent electrode fingers of the second transducer.

7. The surface acoustic wave filter of claim 6, wherein the electrode pitch of a plurality of the adjacent electrodes of the second transducer is defined by a space of the 1/4 wave length λ of the surface acoustic wave corresponding to the frequency Fₓ.

8. The surface acoustic wave filter of claim 7, wherein the frequency fₓ defining the electrode pitch of a plurality of the adjacent electrodes of the second transducer approximately corresponds to the frequency f₁ and the second transducer comprises an unweighted electrode with a constant cross width.

9. The surface acoustic wave filter of claim 6, wherein the electrode pitch of a plurality of the adjacent electrodes of the second transducer is defined by a space of the 1/2 wave length λ of the surface acoustic wave corresponding to the frequency f₁ of an unweighted electrode with a constant cross width.

10. The surface acoustic wave filter of claim 8 or 9, wherein the electrode pitch of a plurality of the adjacent electrodes of the first transducer is defined by a space of the 1/4 wave length λ of the surface acoustic wave corresponding to the frequency f₀.

11. A surface acoustic wave filter, comprising:
a piezoelectric substrate (102);
a first transducer (301) including cob-shaped electrodes with a plurality of electrode fingers crossing each other formed on one major surface of the piezoelectric substrate (102); and
a second transducer (501) including comb-shaped electrodes with a plurality of electrode fingers crossing each other formed on the one major surface of the piezoelectric substrate (102) and being faced to the first transducer (301);
wherein the filter has a frequency passband width Δf₀ whose the center frequency is f₀:
the filter being characterized in that an electrode pitch of the first transducer and that of the second transducer comply with;
$\text{f₁ ≦ f₀ - Δf₀/6 - Δf₁/6}$
or
$\text{f₁ ≧ f₀ + Δf₀/6 + Δf₁/6,}$
wherein Δf₀ stands for a frequency passband width of the first transducer, f₀ for the center frequency of Δf₀, Δf₁ for a frequency passband width of the second transducer, and f₁ for the center frequency of Δf₁.

## Patentansprüche

1. Akustisches Oberflächenwellen-Filter, das aufweist:
ein piezoelektrisches Substrat (102);
einen ersten Transducer (103), der kammförmige Elektroden mit einer Vielzahl von einander gegenüberliegenden Elektrodenfingern umfaßt, die auf einer Hauptoberfläche des piezoelektrischen Substrats (102) gebildet sind; und
einen zweiten Transducer (105), der kammförmige Elektroden mit einer Vielzahl von einander gegenüberliegenden Elektrodenfingern umfaßt, die auf der einen Hauptoberfläche des piezoelektrischen Substrats (102) gebildet sind, und der dem ersten Transducer (103) gegenüberliegt;
wobei die Amplitude/Frequenz-Kennlinie des Filters einen Frequenz-Durchlaßbereich in der Nähe der Frequenz f₀ hat;
dadurch gekennzeichnet, daß der Elektrodenabstand des ersten Transducers und der Elektrodenabstand des zweiten Transducers die Bedingung
$\text{| f₁ - f₂ | ≧ 1/8 ( Δf₁ + Δf₂ )}$
erfüllen; dabei ist Δf₁ die Frequenz-Durchlaßbereich-Breite des ersten Transducers, Δf₂ die Frequenz-Durchlaßbereich-Breite des zweiten Transducers, f₁ die Frequenz des ersten Transducers, die den Elektrodenabstand des ersten Transducers festlegt, und f₂ die Frequenz des zweiten Transducers, die den Elektrodenabstand des zweiten Transducers festlegt.

2. Akustisches Oberflächenwellen-Filter gemäß Anspruch 1, wobei der Elektrodenabstand einer Vielzahl der benachbarten Elektroden des ersten Transducers, und der Elektrodenabstand einer Vielzahl der benachbarten Elektroden des zweiten Transducers durch ein Viertel der den Frequenzen f₁ bzw. f₂ entsprechenden Wellenlänge λ der akustischen Oberflächenwelle festgelegt sind.

3. Akustisches Oberflächenwellen-Filter gemäß Anspruch 1, wobei mindestens eine der Frequenzen f₁ des ersten Transducers und f₂ des zweiten Transducers ungefähr der Frequenz f₀ des Filters entspricht.

4. Akustisches Oberflächenwellen-Filter gemäß Anspruch 3, wobei der ungefähr der Frequenz f₀ entsprechende Elektrodenabstand der Elektrodenfinger des Transducers durch ein Viertel der der Frequenz f₀ entsprechenden Wellenlänge λ der akustischen Oberflächenwelle festgelegt ist.

5. Akustisches Oberflächenwellen-Filter gemäß Anspruch 3, wobei der ungefähr der Frequenz f₀ entsprechende Elektrodenabstand der Elektrodenfinger durch die Hälfte der der Frequenz f₀ entsprechenden Wellenlänge λ der akustischen Oberflächenwelle festgelegt ist.

6. Akustisches Oberflächenwellen-Filter, das aufweist:
ein piezoelektrisches Substrat (102);
einen ersten Transducer (301), der kammförmige Elektroden mit einer Vielzahl von einander gegenüberliegenden Elektrodenfingern umfaßt, die auf einer Hauptoberfläche des piezoelektrischen Substrats (102) gebildet sind; und
einen zweiten Transducer (303), der kammförmige Elektroden mit einer Vielzahl von einander gegenüberliegenden Elektrodenfingern umfaßt, die auf der einen Hauptoberfläche des piezoelektrischen Substrats (102) gebildet sind, und der dem ersten Transducer (301) gegenüberliegt;
wobei das Filter eine Frequenz-Durchlaßbereich-Breite Δf₀ hat, deren Mittenfrequenz f₀ ist;
dadurch gekennzeichnet, daß der Elektrodenabstand des ersten Transducers und der Elektrodenabstand des zweiten Transducers die Bedingung
${\text{4f}}_{\text{x}} \text{- f₁ ≧ 3f₀ + Δf₀/2 + Δf₁/2}$
oder
${\text{4f}}_{\text{x}} \text{- f₁ ≦ 3f₀ + Δf₀/2 - Δf₁/2}$
erfüllen; dabei ist Δf₀ die Frequenz-Durchlaßbereich-Breite des ersten Transducers, f₀ die Mittenfrequenz von Δf₀, Δf₁ die Frequenz-Durchlaßbereich-Breite des zweiten Transducers, f₁ die Mittenfrequenz von Δf₁, und fₓ die Frequenz, die einen Elektrodenabstand der benachbarten Elektrodenfinger des zweiten Transducers festlegt.

7. Akustisches Oberflächenwellen-Filter gemäß Anspruch 6, wobei der Elektrodenabstand einer Vielzahl der benachbarten Elektroden des zweiten Transducers durch ein Viertel der der Frequenz fₓ entsprechenden Wellenlänge λ der akustischen Oberflächenwelle festgelegt ist.

8. Akustisches Oberflächenwellen-Filter gemäß Anspruch 7, wobei die Frequenz fₓ, die den Elektrodenabstand einer Vielzahl der benachbarten Elektroden des zweiten Transducers festlegt, ungefähr der Frequenz f₁ entspricht, und der zweite Transistor eine ungewichtete Elektrode mit einer konstanten Querbreite aufweist.

9. Akustisches Oberflächenwellen-Filter gemäß Anspruch 6, wobei der Elektrodenabstand einer Vielzahl der benachbarten Elektroden des zweiten Transducers durch die Hälfte der der Frequenz f₁ einer ungewichteten Elektrode mit einer konstanten Querbreite entsprechenden Wellenlänge λ der akustischen Oberflächenwelle festgelegt ist.

10. Akustisches Oberflächenwellen-Filter gemäß Anspruch 8 oder 9, wobei der Elektrodenabstand einer Vielzahl der benachbarten Elektroden des ersten Transducers durch ein Viertel der der Frequenz f₀ entsprechenden Wellenlänge λ der akustischen Oberflächenwelle festgelegt ist.

11. Akustisches Oberflächenwellen-Filter, das aufweist:
ein piezoelektrisches Substrat (102);
einen ersten Transducer (301), der kammförmige Elektroden mit einer Vielzahl von einander gegenüberliegenden Elektrodenfingern umfaßt, die auf einer Hauptoberfläche des piezoelektrischen Substrats (102) gebildet sind; und
einen zweiten Transducer (501), der kammförmige Elektroden mit einer Vielzahl von einander gegenüberliegenden Elektrodenfingern umfaßt, die auf der einen Hauptoberfläche des piezoelektrischen Substrats (102) gebildet sind, und der dem ersten Transducer (301) gegenüberliegt;
wobei das Filter eine Frequenz-Durchlaßbereich-Breite Δf₀ hat, deren Mittenfrequenz f₀ ist;
dadurch gekennzeichnet, daß der Elektrodenabstand des ersten Transducers und der Elektrodenabstand des zweiten Transducers die Bedingung
$\text{f₁ ≦ f₀ - Δf₀/6 - Δf₁/6}$
oder
$\text{f₁ ≧ f₀ + Δf₀/6 + Δf₁/6}$
erfüllen; dabei ist Δf₀ die Frequenz-Durchlaßbereich-Breite des ersten Transducers, f₀ die Mittenfrequenz von Δf₀, Δf₁ die Frequenz-Durchlaßbereich-Breite des zweiten Transducers, und f₁ die Mittenfrequenz von Δf₁.

## Revendications

1. Filtre à ondes acoustiques de surface comprenant:
un substrat piézoélectrique (102);
un premier transducteur (103) incluant des électrodes conformées en peigne munies d'une pluralité de doigts d'électrode se croisant les uns les autres formées sur une surface principale du substrat piézoélectrique (102); et
un second transducteur (105) incluant des électrodes conformées en peigne munies d'une pluralité de doigts d'électrode se croisant les uns les autres formées sur la surface principale du substrat piézoélectrique (102) et faisant face au premier transducteur (103),
dans lequel une caractéristique fréquence-amplitude du filtre présente une bande passante en fréquence au voisinage de la caractéristique fréquence-amplitude d'une fréquence f₀,
le filtre étant caractérisé en ce qu'un pas d'électrode du premier transducteur et en ce que celui du second transducteur satisfont la relation suivante:
$\text{| f₁ - f₂ | ≧ 1/8 (Δf₁ + Δf₂),}$
où Δf₁ représente la largeur de la bande passante en fréquence du premier transducteur, Δf₂ représente la largeur de la bande passante en fréquence du second transducteur, f₁ représente la fréquence du premier transducteur définissant le pas d'électrode du premier transducteur et f₂ représente la fréquence du second transducteur définissant le pas d'électrode du second transducteur.

2. Filtre à ondes acoustiques de surface selon la revendication 1, dans lequel le pas d'électrode d'une pluralité d'électrodes adjacentes du premier transducteur et le pas d'électrode d'une pluralité d'électrodes adjacentes du second transducteur sont définis par un espace de 1/4 de la longueur d'onde λ de l'onde acoustique de surface correspondant aux fréquences f₁ et f₂.

3. Filtre à ondes acoustiques de surface selon la revendication 1, dans lequel au moins une fréquence prise parmi la fréquence f₁ du premier transducteur et la fréquence f₂ du second transducteur correspond approximativement à la fréquence f₀ du filtre.

4. Filtre à ondes acoustiques de surface selon la revendication 3, dans lequel le pas d'électrode des doigts d'électrode du transducteur correspondant approximativement à la fréquence f₀ est défini par un espace de 1/4 de la longueur d'onde λ de l'onde acoustique de surface correspondant à la fréquence f₀.

5. Filtre à ondes acoustiques de surface selon la revendication 3, dans lequel le pas d'électrode des doigts d'électrode du transducteur correspondant approximativement à la fréquence f₀ est défini par un espace de 1/2 de la longueur d'onde λ de l'onde acoustique de surface correspondant à la fréquence f₀.

6. Filtre à ondes acoustiques de surface comprenant:
un substrat piézoélectrique (102);
un premier transducteur (301) incluant des électrodes conformées en peigne munies d'une pluralité de doigts d'électrode se croisant les uns les autres formées sur une surface principale du substrat piézoélectrique (102); et
un second transducteur (303) incluant des électrodes conformées en peigne munies d'une pluralité de doigts d'électrode se croisant les uns les autres formées sur la surface principale du substrat piézoélectrique (102) et faisant face au premier transducteur (301),
dans lequel le filtre présente une largeur de bande passante de fréquence Δf₀ dont la fréquence centrale est f₀;
le filtre étant caractérisé en ce qu'un pas d'électrode du premier transducteur et en ce que celui du second transducteur satisfont la relation suivante:
${\text{4f}}_{\text{x}} \text{- f₁ ≧ 3f₀ + Δf₀/2 + Δf₁/2}$
ou
${\text{4f}}_{\text{x}} \text{- f₁ ≦ 3f₀ - Δf₀/2 - Δf₁/2,}$
où Δf₀ représente une largeur de la bande passante en fréquence du premier transducteur, f₀ représente la fréquence centrale de Δf₀, Δf₁ représente une largeur de la bande passante en fréquence du second transducteur, f₁ représente la fréquence centrale de Δf₁ et fₓ représente la fréquence définissant un pas d'électrode des doigts d'électrode adjacents du second transducteur.

7. Filtre à ondes acoustiques de surface selon la revendication 6, dans lequel le pas d'électrode d'une pluralité d'électrodes adjacentes du second transducteur est défini par un espace de 1/4 de la longueur d'onde λ de l'onde acoustique de surface correspondant à la fréquence fₓ.

8. Filtre à ondes acoustiques de surface selon la revendication 7, dans lequel la fréquence fₓ définissant le pas d'électrode d'une pluralité des électrodes adjacentes du second transducteur correspond approximativement à la fréquence f₁ et le second transducteur comprend une électrode non pondérée présentant une largeur de croisement constante.

9. Filtre à ondes acoustiques de surface selon la revendication 6, dans lequel le pas d'électrode d'une pluralité d'électrodes adjacentes du second transducteur est défini par un espace de 1/2 de la longueur d'onde λ de l'onde acoustique de surface correspondant à la fréquence f₁ d'une électrode non pondérée présentant une largeur de croisement constante.

10. Filtre à ondes acoustiques de surface selon la revendication 8 ou 9, dans lequel le pas d'électrode d'une pluralité d'électrodes adjacentes du premier transducteur est défini par un espace de 1/4 de la longueur d'onde λ de l'onde acoustique de surface correspondant à la fréquence f₀.

11. Filtre à ondes acoustiques de surface comprenant:
un substrat piézoélectrique (102);
un premier transducteur (301) incluant des électrodes conformées en peigne munies d'une pluralité de doigts d'électrode se croisant les uns les autres formées sur une surface principale du substrat piézoélectrique (102); et
un second transducteur (501) incluant des électrodes conformées en peigne munies d'une pluralité de doigts d'électrode se croisant les uns les autres formées sur la surface principale du substrat piézoélectrique (102) et faisant face au premier transducteur (301),
dans lequel le filtre présente une largeur de bande passante en fréquence Δf₀ dont la fréquence centrale est f₀,
le filtre étant caractérisé en ce qu un pas d'électrode du premier transducteur et en ce que celui du second transducteur satisfont la relation:
$\text{f₁ ≦ f₀ - Δf₀/6 - Δf₁/6}$
ou
$\text{f₁ ≧ f₀ + Δf₀/6 + Δf₁/6,}$
où Δf₀ représente une largeur de la bande passante en fréquence du premier transducteur, f₀ représente la fréquence centrale de Δf₀, Δf₁ représente la largeur de la bande passante en fréquence du second transducteur et f₁ représente la fréquence centrale de Δf₁.
